# EUROPEAN PATENT APPLICATION

(11) **EP 4 507 183 A1**
(43) Date of publication of application: **12.02.2025**
(21) Application number: 24189131.6
(22) Date of filing: 17.07.2024
(51) Int. Cl.: H02M 7/48, H02M 7/00, H05K 7/14, H02G 5/00

(54) **SYSTEMS AND METHODS FOR LOWER COMMUTATION LOOP INDUCTANCE BULK CAPACITOR**

(30) Priority: 11.08.2023 US 202318448718
(71) Applicant: BorgWarner US Technologies LLC, Wilmington, DE 19801 (US)
(72) Inventor: UGARE, Chetan, Nuremberg (DE); HASSAN, Syed Shah Fahad, Erlangen (DE); APELSMEIER, Andreas, Pollenfeld (DE)
(74) Representative: Office Freylinger

(57) **Abstract**

A bulk capacitor assembly for an inverter includes a stacked busbar, the stacked busbar including a first direct current (DC) busbar and a second DC busbar; one or more first capacitors on a first side of the stacked busbar, the one or more first capacitors electrically connected to the first DC busbar and the second DC busbar; and one or more second capacitors on a second side of the stacked busbar, the first side being opposite to the second side, the one or more second capacitors electrically connected to the first DC busbar and the second DC busbar.

## Description

### TECHNICAL FIELD

Various embodiments of the present disclosure relate generally to systems and methods for lower commutation loop inductance bulk capacitors, and more particularly, to a bulk capacitor assembly including a stacked busbar for an inverter.

### BACKGROUND

For a traction inverter, a power module is considered to be an important component of a power conversion system. The efficiency of the system may be proportional to the switching losses occurring in the power module. However, the commutation cell inductance of a power conversion system may prevent mitigating switching losses.

The present disclosure is directed to overcoming one or more of these above-referenced challenges.

### SUMMARY OF THE DISCLOSURE

In some aspects, the techniques described herein relate to a bulk capacitor assembly for an inverter, the bulk capacitor assembly including: a stacked busbar, the stacked busbar including a first direct current (DC) busbar and a second DC busbar; one or more first capacitors on a first side of the stacked busbar, the one or more first capacitors electrically connected to the first DC busbar and the second DC busbar; and one or more second capacitors on a second side of the stacked busbar, the first side being opposite to the second side, the one or more second capacitors electrically connected to the first DC busbar and the second DC busbar.

In some aspects, the techniques described herein relate to a bulk capacitor assembly, wherein the first DC busbar includes one or more first apertures, and wherein the one or more first capacitors are electrically connected to the second DC busbar through the one or more first apertures.

In some aspects, the techniques described herein relate to a bulk capacitor assembly, wherein the second DC busbar includes one or more second apertures, the one or more second apertures corresponding to the one or more first apertures.

In some aspects, the techniques described herein relate to a bulk capacitor assembly, wherein the first DC busbar includes one or more first apertures, wherein the one or more first capacitors are electrically connected to the first DC busbar at the one or more first apertures, and wherein the second DC busbar includes one or more second apertures, the one or more second apertures corresponding to the one or more first apertures.

In some aspects, the techniques described herein relate to a bulk capacitor assembly, wherein the one or more first capacitors include: a first capacitor electrically connected to the first DC busbar, a second capacitor electrically connected to the second DC busbar, and a conductive plate electrically connecting the first capacitor to the second capacitor in a series configuration, wherein electrical current is configured to flow from the first DC busbar, through the first capacitor, through the conductive plate, through the second capacitor, and to the second DC busbar.

In some aspects, the techniques described herein relate to a bulk capacitor assembly, further including: a power module electrically connected to the first DC busbar and the second DC busbar, wherein the power module is positioned between the first side of the stacked busbar and the second side of the stacked busbar.

In some aspects, the techniques described herein relate to a bulk capacitor assembly, further including: a heat sink assembly, wherein the heat sink assembly is positioned with the power module between the first side of the stacked busbar and the second side of the stacked busbar, and wherein the heat sink assembly is configured to cool the one or more first capacitors, the one or more second capacitors, the stacked busbar, and the power module.

In some aspects, the techniques described herein relate to a bulk capacitor assembly, further including: a printed circuit board extending across the first side of the stacked busbar and the second side of the stacked busbar.

In some aspects, the techniques described herein relate to a bulk capacitor assembly, wherein a cross-section of the bulk capacitor assembly includes: the one or more first capacitors on the first side of the stacked busbar; the one or more second capacitors on the second side of the stacked busbar; a power module between the first side of the stacked busbar and the second side of the stacked busbar; and a heat sink assembly between the first side of the stacked busbar and the second side of the stacked busbar.

In some aspects, the techniques described herein relate to an inverter including: the bulk capacitor assembly; a power module configured to switch direct current electricity into alternating current; and a heat sink assembly, wherein the heat sink assembly is configured to cool the power module and the bulk capacitor assembly.

In some aspects, the techniques described herein relate to a vehicle including the inverter.

In some aspects, the techniques described herein relate to a system including: an inverter configured to convert DC power from a battery to AC power to drive a motor, wherein the inverter includes: a power module; and a bulk capacitor assembly, the bulk capacitor assembly including: a stacked busbar, the stacked busbar including a first direct current (DC) busbar and a second DC busbar; one or more first capacitors on a first side of the stacked busbar, the one or more first capacitors electrically connected to the first DC busbar and the second DC busbar; and one or more second capacitors on a second side of the stacked busbar, the first side being opposite to the second side, the one or more second capacitors electrically connected to the first DC busbar and the second DC busbar.

In some aspects, the techniques described herein relate to a system, further including: a heat sink assembly, wherein the heat sink assembly is positioned with the power module between the first side of the stacked busbar and the second side of the stacked busbar, and wherein the heat sink assembly is configured to cool the one or more first capacitors, the one or more second capacitors, the stacked busbar, and the power module; and a printed circuit board extending across the first side of the stacked busbar and the second side of the stacked busbar.

In some aspects, the techniques described herein relate to a system, wherein the heat sink assembly includes: a first cooling channel; and a second cooling channel, wherein the power module is provided between the first cooling channel and the second cooling channel.

In some aspects, the techniques described herein relate to a system, wherein the one or more first capacitors include: a first capacitor electrically connected to the first DC busbar, a second capacitor electrically connected to the second DC busbar, and a conductive plate electrically connecting the first capacitor to the second capacitor in a series configuration, wherein electrical current is configured to flow from the first DC busbar, through the first capacitor, through the conductive plate, through the second capacitor, and to the second DC busbar.

In some aspects, the techniques described herein relate to a system, wherein a number of the one or more first capacitors is the same as a number of the one or more second capacitors.

In some aspects, the techniques described herein relate to a stacked busbar assembly for a bulk capacitor assembly for an inverter, the stacked busbar assembly including: a first direct current (DC) busbar; and a second DC busbar, wherein the first DC busbar and the second DC busbar are arranged for one or more first capacitors to be provided on a first side of the stacked busbar assembly and for one or more second capacitors to be provided on a second side of the stacked busbar assembly, wherein the first side is opposite to the second side.

In some aspects, the techniques described herein relate to a stacked busbar assembly, wherein the first DC busbar includes one or more first apertures, wherein the one or more first capacitors are to be electrically connected to the second DC busbar through the one or more first apertures, and wherein the second DC busbar includes one or more second apertures, the one or more second apertures corresponding to the one or more first apertures.

In some aspects, the techniques described herein relate to a stacked busbar assembly, wherein the first DC busbar includes one or more first apertures, wherein the one or more first capacitors are to be electrically connected to the first DC busbar at the one or more first apertures, and wherein the second DC busbar includes one or more second apertures, the one or more second apertures corresponding to the one or more first apertures.

In some aspects, the techniques described herein relate to a stacked busbar assembly, wherein the first DC busbar includes a first connection aperture and a through aperture, wherein the second DC busbar includes a second connection aperture corresponding to the through aperture, and an isolation aperture corresponding to the first connection aperture, wherein the first connection aperture is configured to electrically connect the first DC busbar to a first capacitor of the one or more first capacitors, and wherein the second connection aperture is configured to electrically connect the second DC busbar to a second capacitor of the one or more first capacitors through the first through aperture.

It is to be understood that both the foregoing general description and the following detailed description are exemplary and explanatory only and are not restrictive of the disclosed embodiments, as claimed.

### BRIEF DESCRIPTION OF THE DRAWINGS

The accompanying drawings, which are incorporated in and constitute a part of this specification, illustrate various exemplary embodiments and together with the description, serve to explain the principles of the disclosed embodiments.
FIG. 1 depicts an exemplary system infrastructure for a vehicle including a combined inverter and converter, according to one or more embodiments.
FIG. 2 depicts an electrical power schematic of an inverter in a connected system, according to one or more embodiments.
FIG. 3 depicts a power module and a heat sink assembly for a combined inverter and converter, according to one or more embodiments.
FIG. 4 depicts a cross-sectional view of a bulk capacitor assembly for an inverter, according to one or more embodiments.
FIG. 5 depicts a side view of a bulk capacitor assembly for an inverter, according to one or more embodiments.
FIG. 6 depicts an exploded view of a bulk capacitor assembly for an inverter with a heat sink, a power module, and a printed circuit board, according to one or more embodiments.
FIGS. 7A and 7B depict a top view and a bottom view, respectively, of one or more first capacitors provided on a stacked busbar, according to one or more embodiments.
FIG. 8 depicts a portion of a bulk capacitor assembly for a first mounting stage, according to one or more embodiments.
FIG. 9 depicts a portion of a bulk capacitor assembly for a second mounting stage, according to one or more embodiments
FIG. 10 depicts a portion of a bulk capacitor assembly for a laser welding stage, according to one or more embodiments.
FIG. 11 depicts a finalized bulk capacitor assembly for an inverter, according to one or more embodiments.

### DETAILED DESCRIPTION OF EMBODIMENTS

Both the foregoing general description and the following detailed description are exemplary and explanatory only and are not restrictive of the features, as claimed. As used herein, the terms "comprises," "comprising," "has," "having," "includes," "including," or other variations thereof, are intended to cover a non-exclusive inclusion such that a process, method, article, or apparatus that comprises a list of elements does not include only those elements, but may include other elements not expressly listed or inherent to such a process, method, article, or apparatus. In this disclosure, unless stated otherwise, relative terms, such as, for example, "about," "substantially," and "approximately" are used to indicate a possible variation of ±10% in the stated value. In this disclosure, unless stated otherwise, any numeric value may include a possible variation of ±10% in the stated value.

Various embodiments of the present disclosure relate generally to systems and methods for lower commutation loop inductance bulk capacitors, and more particularly, to a bulk capacitor assembly including a stacked busbar for an inverter.

The terminology used below may be interpreted in its broadest reasonable manner, even though it is being used in conjunction with a detailed description of certain specific examples of the present disclosure. Indeed, certain terms may even be emphasized below; however, any terminology intended to be interpreted in any restricted manner will be overtly and specifically defined as such in this Detailed Description section.

As mentioned previously, power modules are important components in the functioning of traction inverters and related systems. Switching losses in power modules may be impacted by switching speeds. In systems including a traction inverter, the commutation cell inductance may be a major limiting factor in achieving higher switching speeds, which may result in higher power losses, considering overshoot voltage may be close to voltage breakdown of the switching transistors.

To mitigate the commutation cell inductance present in the system, some designs have attempted to improve the internal structures of power modules or control the parasitic inductance of busbars connected to the power modules by using different interconnection methods. In other cases, some designs have attempted to improve DC link connections of capacitor bobbins in the system.

To address the issues outlined above, one or more embodiments may include a stacked busbar with arrangements of one or more first capacitors on a first side of the stacked busbar and one or more second capacitors on a second side of the stacked busbar, with the first side being opposite to the second side. The one or more first capacitors may be electrically connected to a power switch via the first side of the stacked busbar. The one or more second capacitors may be electrically connected to the power switch via the second side of the stacked busbar. The one or more first capacitors and the one or more second capacitors may include direct current (DC)-link capacitors for use in an inverter. The arrangement of the one or more first capacitors and the one or more second capacitors on the opposing sides of the stacked busbar may split resulting high speed transient currents into two capacitor elements, which may result in lower overshoot voltages across a connectable power switch during operation. The stacked busbar may include a laminated stacked busbar and other types of stacked busbars.

One or more embodiments may enable high speed switching of the connectable power switch. One or more embodiments may connect the one or more first capacitors to the one or more second capacitors in a parallel configuration. The parallel connection of the one or more first capacitors to the one or more second capacitors may reduce the parasitic inductance in a connectable power switch in half as compared to a configuration incorporating a single DC-link capacitor.

One or more embodiments may include a heat sink assembly positioned between the one or more first capacitors and the one or more second capacitors for engaging in active cooling of the one or more first capacitors and the one or more second capacitors. In one or more embodiments, for each of the one or more first capacitors and the one or more second capacitors, a first capacitor may be connected to a first DC busbar, and a second capacitor may be connected to a second DC busbar. The first capacitor may connect to the second capacitor in a series configuration with a conductive plate. In one or more embodiments, an electrical current may be configured to flow from the first DC busbar, through the first capacitor, through the conductive plate, through the second capacitor, and to the second DC busbar. The first DC busbar may connect to a positive charge of a DC battery, and the second DC busbar may connect to a negative charge of the DC battery, or vice versa. In one or more embodiments, the one or more first capacitors and the one or more second capacitors may include metalized polypropylene capacitors, ceramic capacitors, NanoLam^{™} based capacitors, and other types of capacitors.

One or more embodiments may reduce the parasitic inductance of the switching loops for a connectable power module, which may lead to lower switching power losses. As such, the semiconductor area of the connectable power switch may be reduced while maintaining similar performance compared to power switches with a larger semiconductor area. Additionally, reduced parasitic inductance may enable EMC compliance with minimal efforts. One or more embodiments may provide for robust DC-link capacitors due to active cooling on both sides of the connectable power module.

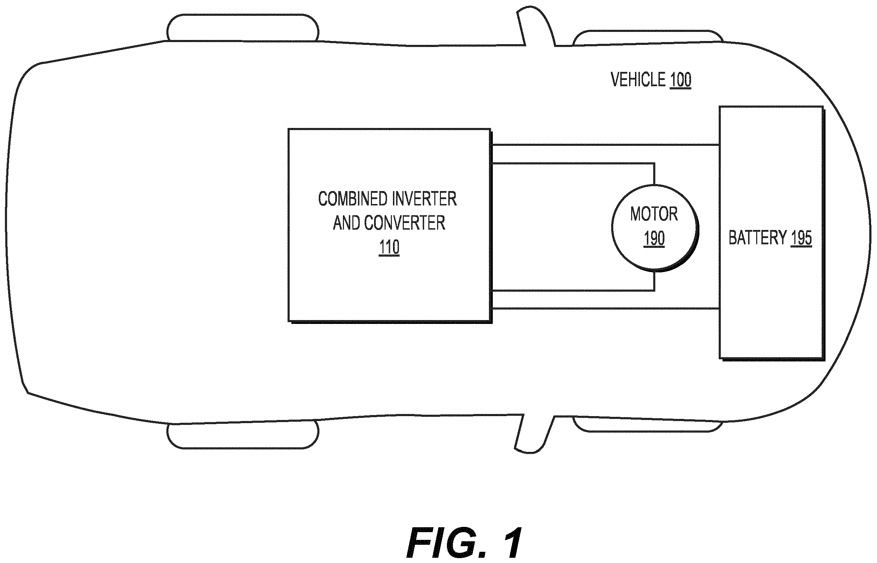

FIG. 1 depicts an exemplary system infrastructure for a vehicle including a combined inverter and converter, according to one or more embodiments. In the context of this disclosure, the combined inverter and converter may be referred to as an inverter. As shown in FIG. 1, electric vehicle 100 may include an inverter 110, a motor 190, and a battery 195. The inverter 110 may include components to receive electrical power from an external source and output electrical power to charge battery 195 of electric vehicle 100. The inverter 110 may convert DC power from battery 195 in electric vehicle 100 to AC power, to drive motor 190 of the electric vehicle 100, for example, but the embodiments are not limited thereto. The inverter 110 may be bidirectional, and may convert DC power to AC power, or convert AC power to DC power, such as during regenerative braking, for example. Inverter 110 may be a three-phase inverter, a single-phase inverter, or a multi-phase inverter.

As described below, inverter 110 may include a bulk capacitor assembly and a power module connectable to the bulk capacitor assembly. The bulk capacitor assembly may include a stacked busbar, which may include a first direct current (DC) busbar and a second DC busbar. The first DC busbar may be connected to a positive DC charge of a battery (e.g., battery 195), and the second DC busbar may be connected to a negative DC charge of the battery, or vice versa. The stacked busbar may be used to transfer electrical power from the battery 195 to a connectable power module and one or more DC-link capacitors connected to the stacked busbar.

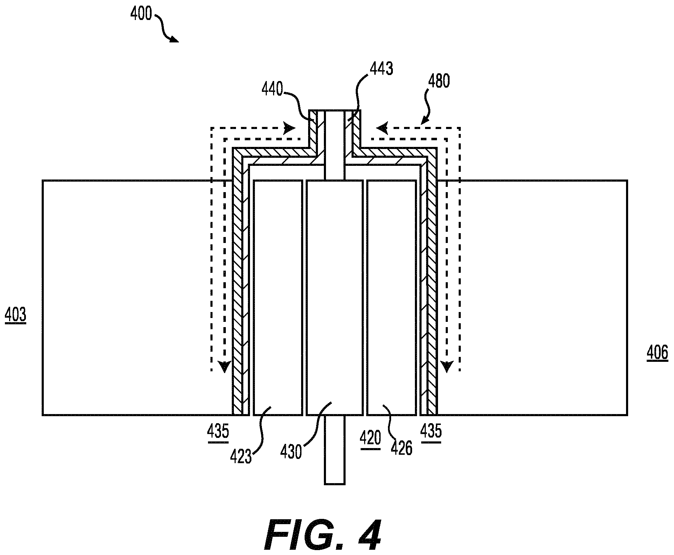

The first DC busbar and the second DC busbar may be stacked closely together to reduce parasitic inductance of the switching loop of the power module. One or more first capacitors may be provided on a first side of the stacked busbar. One or more second capacitors may be provided on a second side of the stacked busbar. Further details regarding specific arrangements and configurations of the power module, the one or more first capacitors, the one or more second capacitors, and the stacked busbar are discussed in relation to FIGS. 4-11 in the following paragraphs.

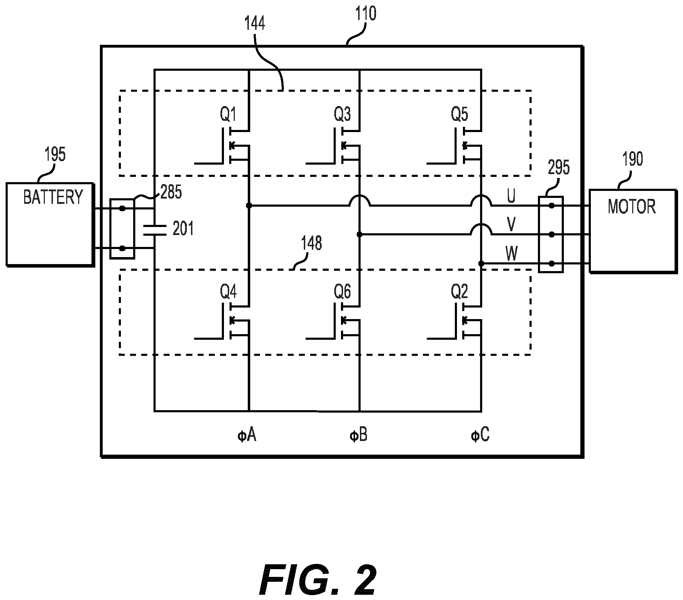

FIG. 2 depicts an electrical power schematic of an inverter in a connected system, according to one or more embodiments. The inverter may be used to convert DC power from a battery in an electric vehicle to AC power, to drive an electric motor of the electric vehicle, for example, but the embodiments are not limited thereto. Additionally, the inverter may be bidirectional, and used to convert DC power to AC power, or to convert AC power to DC power.

As shown in FIG. 2, inverter 110 may be connected to battery 195 (DC power supply) and motor 190. Inverter 110 may include upper phase switches 144 and lower phase switches 148 as components of a power module. A first phase (ΦA) may include switches Q1 and Q4, a second phase (ΦB) may include switches Q3 and Q6, and a third phase (ΦC) may include switches Q5 and Q2, as illustrated in FIG. 2. Upper phase switches 144 may include first phase switch Q1, second phase switch Q3, and third phase switch Q5. Lower phase switches 148 may include first phase switch Q4, second phase switch Q6, and third phase switch Q2. Switches Q1-Q6 may be metal-oxide-semiconductor field-effect transistors (MOSFET), for example, but are not limited thereto. Although FIG. 2 illustrates a three-phase inverter, the disclosure is not limited thereto, and may include single phase or multi-phase or multi-level inverters.

Upper phase switches 144 and lower phase switches 148 may be driven by a PWM signal generated by one or more controllers to convert DC power delivered via the set of input terminals 285 at bulk capacitor 201 to three phase AC power at outputs U, V, and W (correlating with phases A, B, and C, respectively) via the set of output terminals 295 to motor 190. In this disclosure, the bulk capacitor 201 may be referred to as the capacitor components of a bulk capacitor assembly, for which various embodiments are disclosed. Additionally, although FIG. 2 illustrates a three-phase inverter, the disclosure is not limited thereto, and may include single phase or multi-phase or multi-level inverters.

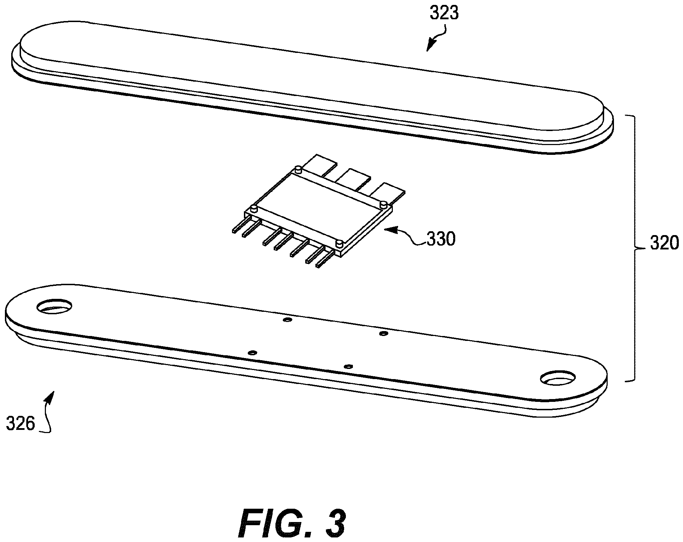

FIG. 3 depicts an exploded view of a power module and a heat sink assembly for an inverter, according to one or more embodiments. For example, power module 330 may be compatible with the inverter 110 shown in FIGS. 1 and 2, and may be used for switching operations for the inverter 110. As depicted, the power module 330 is between a first cooling channel 323 and a second cooling channel 326 of a heat sink assembly 320. The power module 330 may include one or more silicon carbide (SiC)-based power modules that deliver relatively high power densities and efficiencies needed to extend battery range and performance, although other semiconductor switches may be relied upon. The power module 330 may contain circuitry and components configured to convert direct current (DC) from the electric vehicle battery to alternating current (AC) current (and vice versa), which can be utilized by the motor 190, for example, that drives the propulsion system. The power module 330 may be installed on one or more power board assemblies. The power module 330 may include a combination of transistors, diodes, metal oxide semiconductor field effect transistors (MOSFETs), insulated-gate bipolar transistors (IGBTs), and silicon-controlled rectifiers (SCRs). The power module 330 may include a combination of transistors configured to both a half-bridge and H-bridge configuration, which may allow for the switch ability of the direction of the current through a motor from a single voltage power supply. The power module 330 may also include three or more transistors for inverting applications such as switching direct current (DC) electricity into alternating current (AC) electricity.

During operation, the first cooling channel 323 and the second cooling channel 326 may provide cooling for the power module 330, the bulk capacitor 201, and a stacked busbar (see FIG. 4) connectable to the power module 330 and the bulk capacitor 201. The stacked busbar may include a first side and a second side, the first side including one or more first capacitors thereon, and the second side including one or more second capacitors thereon. The one or more first capacitors may be electrically connected to the power module 330 via the first side of the stacked busbar. The one or more second capacitors may be electrically connected to the power module 330 via the second side of the stacked busbar.

The first cooling channel 323 may provide cooling to a first side of the stacked busbar and one or more first capacitors provided on the first side of the stacked busbar. The second cooling channel 326 may provide cooling to a second side of the stacked busbar and one or more second capacitors provided on the second side of the stacked busbar. In some cases, the first cooling channel 323 may physically couple to the first side of the stacked busbar, and the second cooling channel 326 may physically couple to the second side of the stacked busbar, for providing adequate cooling to the above-mentioned components.

FIG. 4 depicts a cross-sectional view of a bulk capacitor assembly for an inverter, according to one or more embodiments. As depicted, bulk capacitor assembly 400 includes one or more first capacitors 403, one or more second capacitors 406, a stacked busbar 435 including a first DC busbar 440 and a second DC busbar 443, a heat sink assembly 420 including a first cooling channel 423 and a second cooling channel 426, and a power module 430 positioned between the first cooling channel 423 and the second cooling channel 426. The bulk capacitor assembly 400 may include the bulk capacitor 201. The bulk capacitor assembly 400 may be used in the inverter 110, for example. The heat sink assembly 420 may be similar to or interchangeable with the heat sink assembly 320. Additionally, the power module 430 may be similar to or interchangeable with the power module 330. The stacked busbar 435 may include laminated busbar assemblies.

The one or more first capacitors 403 may include one or more capacitor bobbins arranged on a first side of the stacked busbar 435. The one or more second capacitors 406 may include one or more capacitor bobbins arranged on a second side of the stacked busbar 435, where the second side is opposite to the first side. The one or more first capacitors 403 and the one or more second capacitors 406 may include various types of capacitors such as metalized polypropylene capacitors, ceramic capacitors, NanoLam^{™} based capacitors, and other types of capacitors.

As depicted, the first DC busbar 440 and the second DC busbar 443 are stacked closely together to support the arrangement of the one or more first capacitors 403 and the one or more second capacitors 406 on the first side of the stacked busbar 435 and the second side of the stacked busbar 435, respectively. Though depicted as being provided on the first side and the second side, the one or more first capacitors 403 and the one or more second capacitors 406 may be configured to electrically connect to both the first DC busbar 440 and the second DC busbar 443, the details of which will be discussed with respect to the later figures. Additionally, the first DC busbar 440 and the second DC busbar 443 may receive electrical power from a DC power supply (e.g., the battery 195) to transfer power to the connected components, such as the power module 430, the one or more first capacitors 403, and the one or more second capacitors 406. The first DC busbar 440 may be connected to a positive pole of a DC battery, and the second DC busbar 443 may be connected to a negative pole of the DC battery, or vice versa.

The first cooling channel 423 and the second cooling channel 426 of the heat sink assembly 420 may provide cooling to the stacked busbar 435, the one or more first capacitors 403, the one or more second capacitors 406, and the power module 430. The first cooling channel 423 may provide cooling to the first side of the stacked busbar 435, a first side of the power module 430, and the one or more first capacitors 403. The second cooling channel 426 may provide cooling to the second side of the stacked busbar 435, a second side of the power module 430, and the one or more second capacitors 406.

The power module 430 may include similar components as the power module 330 and may include one or more silicon carbide (SiC)-based power modules that deliver relatively high power densities and efficiencies needed to extend battery range and performance, although other semiconductor switches may be relied upon. The power module 430 may contain circuitry and components configured to convert direct current (DC) from the electric vehicle battery to alternating current (AC) current (and vice versa), which can be utilized by the motor 190, for example, that drives the propulsion system. The power module 430 may be installed on one or more power board assemblies. The power module 430 may include a combination of transistors, diodes, metal oxide semiconductor field effect transistors (MOSFETs), insulated-gate bipolar transistors (IGBTs), and silicon-controlled rectifiers (SCRs). The power module 430 may include a combination of transistors configured to both a half-bridge and H-bridge configuration, which may allow for the switch ability of the direction of the current through a motor from a single voltage power supply. The power module 430 may also include three or more transistors for inverting applications such as switching direct current (DC) electricity into alternating current (AC) electricity. During operation of the bulk capacitor assembly 400, electrical current may be configured to flow in a loop 480 as depicted, where the one or more first capacitors 403 may connect to the one or more second capacitors 406 in a parallel configuration. The power module 430 may be positioned between the first side of the stacked busbar 435 and the second side of the stacked busbar 435.

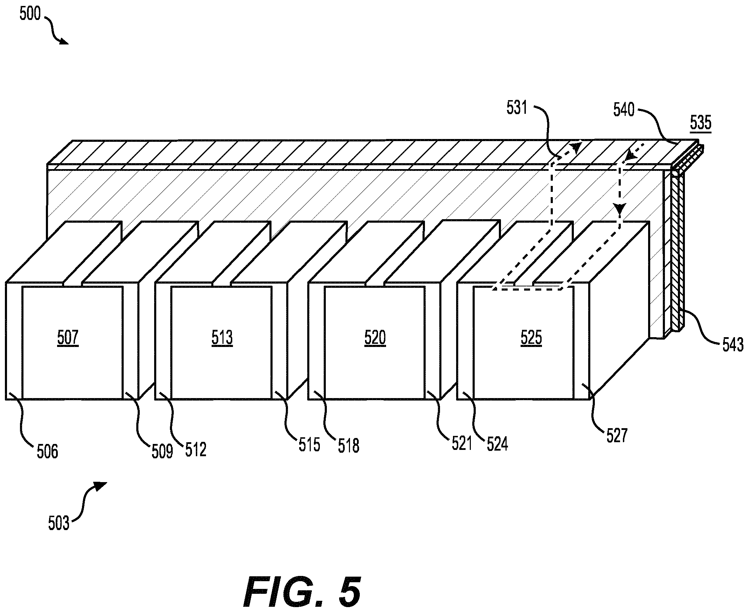

FIG. 5 depicts a side view of a bulk capacitor assembly for an inverter, according to one or more embodiments. As depicted, bulk capacitor assembly 500 may include many of the same components as the bulk capacitor assembly 400 and may be interchangeable with the bulk capacitor assembly 400. The bulk capacitor assembly 500 includes a stacked busbar 535, which includes a first DC busbar 540 and a second DC busbar 543. The stacked busbar 535 may include laminated busbar assemblies. The first DC busbar 540 may be connected to a positive pole of a DC battery (e.g., battery 195), and the second DC busbar may be connected to a negative pole of the DC battery, or vice versa. The stacked busbar 535 may be used to transfer electrical power from the battery 195 to a connectable power module and one or more DC-link capacitors connected to the stacked busbar 535.

FIG. 5 depicts one or more first capacitors 503 provided on a first side of stacked busbar 535. The bulk capacitor assembly 500 may include one or more second capacitors provided on a second side of the stacked busbar 535, similar to bulk capacitor assembly 400, although not depicted in FIG. 5. The one or more first capacitors 503 may include one or more first and second capacitors connected in series. For example, the one or more first capacitors 503 may include a first capacitor 506 connected in series to a second capacitor 509 with a first conductive plate 507, a first capacitor 512 connected in series to a second capacitor 515 with a second conductive plate 513, a first capacitor 518 connected in series to a second capacitor 521 with a third conductive plate 520, and a first capacitor 524 connected in series to a second capacitor 527 with a fourth conductive plate 525. Although FIG. 5 depicts four first and second capacitors connected in series, this disclosure is not limited thereto. Fewer or greater than four first and second capacitors may be implemented depending on the application for use of the bulk capacitor assembly 500.

As depicted, the first DC busbar 540 and the second DC busbar 543 are stacked closely together to support the arrangement of the one or more first capacitors 503 on the first side of the stacked busbar 535. Though depicted as being provided on the first side, the one or more first capacitors 503 may be electrically connected to both the first DC busbar 540 and the second DC busbar 543, the details of which will be discussed with respect to the later figures. Additionally, the first DC busbar 540 and the second DC busbar 543 may receive electrical power from a DC power supply (e.g., the battery 195) to transfer power to the connected components, such as a power module, the one or more first capacitors 503. The first DC busbar 540 may be connected to a positive pole of a DC battery, and the second DC busbar 543 may be connected to a negative pole of the DC battery, or vice versa.

During operation, the bulk capacitor assembly 500 may facilitate flow 531 of electrical current between the stacked busbar 535 and the one or more first capacitors 503. In particular, components of the bulk capacitor assembly 500 may be arranged and electrically connected so that for the first capacitors (e.g., the first capacitor 506, the first capacitor 512, the first capacitor 518, and the first capacitor 524) and the second capacitors (e.g., the second capacitor 509, the second capacitor 515, the second capacitor 521, and the second capacitor 527) connected in series, electrical current may be follow flow 531. For example, as shown in FIG. 5, electrical current may follow flow 531 from the first DC busbar 540, through second capacitor 527, through fourth conductive plate 525, through first capacitor 524, and to the second DC busbar 543. The electrical current may be configured to follow flow 531 in a current loop in parallel through the four first and second capacitors connected in series.

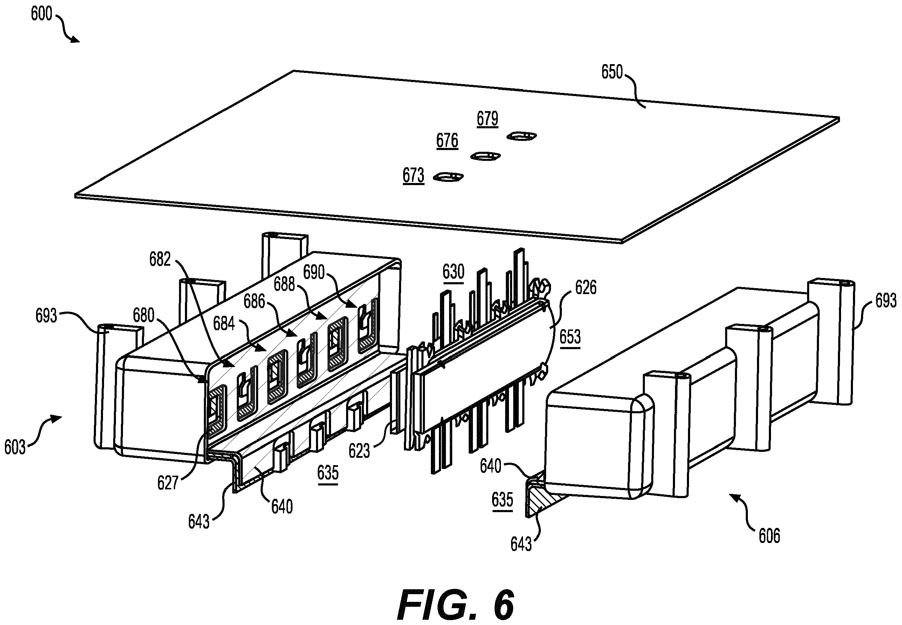

FIG. 6 depicts an exploded view of a bulk capacitor assembly for an inverter with a heat sink, a power module, and a printed circuit board, according to one or more embodiments. As depicted in FIG. 6, bulk capacitor assembly 600 may be similar to the bulk capacitor assembly 400 and the bulk capacitor assembly 500 and may include many of the same components as the bulk capacitor assembly 400 and the bulk capacitor assembly 500. Additionally, many of the components of the bulk capacitor assembly 400 and the bulk capacitor assembly 500 may be interchangeable with the components of the bulk capacitor assembly 600. The bulk capacitor assembly 600 includes a stacked busbar 635, which includes a first DC busbar 640 and a second DC busbar 643. Although FIG. 6 illustrates an exploded view, the first DC busbar 640 and the second DC busbar 643 may be electrically connected as a final assembly.

The bulk capacitor assembly 600 further includes one or more first capacitors 603 provided on a first side of the stacked busbar 635, one or more second capacitors 606 provided on a second side of the stacked busbar 635, a heat sink assembly 653 positioned between the one or more first capacitors 603 and the one or more second capacitors 606, and a printed circuit board (PCB) 650 extending across the first side of the stacked busbar 635 and the second side of the stacked busbar 635. The first side of the stacked busbar 635 and the second side of the stacked busbar 635 may be separable components that may be coupled together via a welding process, for example.

The one or more first capacitors 603 and the one or more second capacitors 606 may be contained within a protective housing 693. A power module 630 may be positioned between a first cooling channel 623 and a second cooling channel 626 of the heat sink assembly 653, similar to how the power module 330 is positioned between the first cooling channel 323 and the second cooling channel 326 (depicted in FIG. 3). The power module 630 may be positioned between the first side of the stacked busbar 635 and the second side of the stacked busbar 635. The one or more first capacitors 603 provided on the first side of the stacked busbar 635 may be electrically connected to the power module 330 via the first side of the stacked busbar 635. The one or more second capacitors 606 provided on the second side of the stacked busbar 635 may be electrically connected to the power module 330 via the second side of the stacked busbar 635.

As depicted, the first DC busbar 640 and the second DC busbar 643 are stacked closely together to support the arrangement of the one or more first capacitors 603 and the one or more second capacitors 606 on the first side of the stacked busbar 635 and the second side of the stacked busbar 635, respectively. In some cases, an insulation material 627 may separate the first DC busbar 640 from the second DC busbar 643. Though depicted as being provided on the first side and the second side, the one or more first capacitors 603 and the one or more second capacitors 606 may be configured to electrically connect to both the first DC busbar 640 and the second DC busbar 643, which will be discussed in the following paragraphs. Additionally, the first DC busbar 640 and the second DC busbar 643 may receive electrical power from a DC power supply (e.g., the battery 195) to transfer power to the connected components, such as the power module 630, the one or more first capacitors 603, and the one or more second capacitors 606. The first DC busbar 640 may be connected to a positive pole of a DC battery, and the second DC busbar 643 may be connected to a negative pole of the DC battery, or vice versa.

One or more apertures may be provided in the first DC busbar 640 and the second DC busbar 643. For example, one or more first apertures in the first DC busbar 640 on the first side of the stacked busbar 635 may include a first aperture 680, a second aperture 682, a third aperture 684, a fourth aperture 686, a fifth aperture 688, and a sixth aperture 690. The second DC busbar 643 may include one or more second apertures corresponding to the one or more first apertures. The one or more second apertures may be similar in size to the size of the one or more first apertures. In some cases, the one or more second apertures may be smaller in size than the size of the one or more first apertures. Each of the above-mentioned apertures may facilitate an electrical connection between a capacitor of the one or more first capacitors 603 and the first DC busbar 640 or the second DC busbar 643. For example, first aperture 680 may be an isolation aperture in first DC busbar 640 corresponding to a connection aperture in second DC busbar 643, and second aperture 682 may be a connection aperture in first DC busbar 640 corresponding to a through aperture in second DC busbar 643. The first DC busbar 640 and the second DC busbar 643 at the second side of the stacked busbar 635 may include a same number of apertures as the number of apertures on the first side, in a mirror configuration, for facilitating an electrical connection of a capacitor of the one or more second capacitors 606 to the first DC busbar 640 or the second DC busbar 643.

The first cooling channel 623 and the second cooling channel 626 may be coupled together to provide cooling for the power module 630, the one or more first capacitors 603, the one or more second capacitors 606, and the stacked busbar 635. The first cooling channel 623 may provide cooling to the first side of the stacked busbar 635 and the one or more first capacitors 603. The second cooling channel 626 may provide cooling to the second side of the stacked busbar 635 and the one or more second capacitors 606. In some cases, the first cooling channel 623 may physically couple to the first side of the stacked busbar 635, and the second cooling channel 626 may physically couple to the second side of the stacked busbar 635 for providing adequate cooling to the above-mentioned components.

One or more apertures 673, 676, and 679 may be provided on the PCB 650 for receiving connectors of the power module 630. As such, the PCB 650 may facilitate connection of the power module 630 to a motor (e.g., the motor 190) and one or more controllers or circuits that may control switching operations of the power module 630.

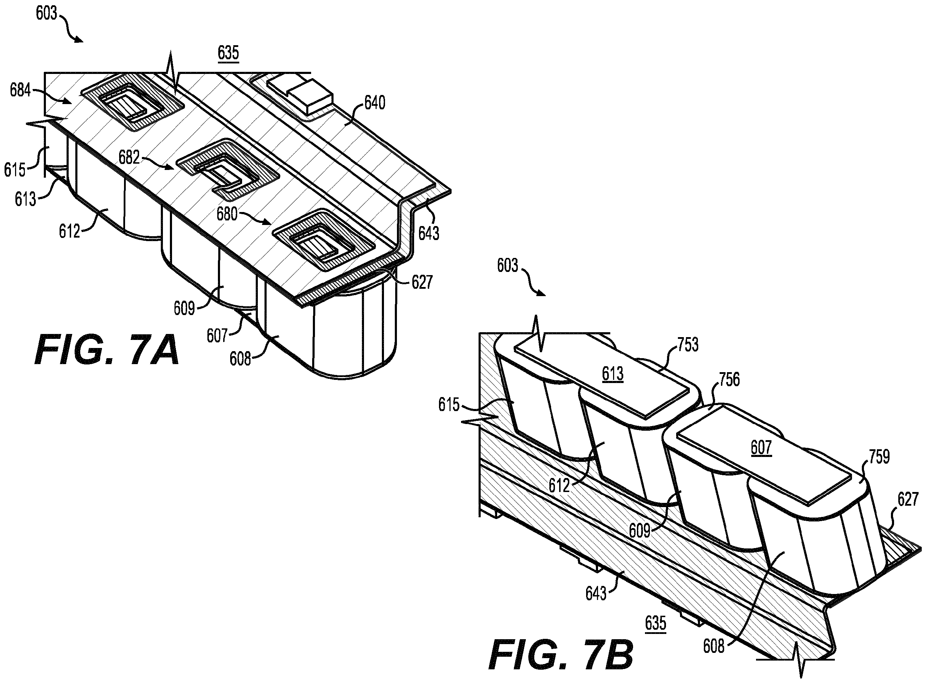

FIGS. 7A and 7B depict a top view and a bottom view, respectively, of one or more first capacitors provided on a stacked busbar, according to one or more embodiments. As depicted, FIG. 7A depicts a top view of the one or more first capacitors 603 on a first side of the stacked busbar 635 without the protective housing 693. The one or more first capacitors 603 may include one or more first and second capacitors connected in series. For example, the one or more first capacitors 603 may include a first capacitor 608 connected in series to a second capacitor 609 with a first conductive plate 607 and a first capacitor 612 connected in series to a second capacitor 615 with a second conductive plate 613. Although FIG. 7A depicts two first and second capacitors connected in series, this disclosure is not limited thereto. Fewer or greater than two first and second capacitors may be implemented depending on the application for use of the bulk capacitor assembly 600.

For each first and second capacitor connected in series among the one or more first capacitors 603, the first capacitor may be electrically connected to the first DC busbar 640, and the second capacitor may be electrically connected to a second DC busbar 643, or vice versa, by way of a respective aperture or window of the one or more first apertures provided for the first DC busbar 640 on the first side of the stacked busbar 635.

For example, the first capacitor 608 may be electrically connected to the second DC busbar 643 at the first aperture 680, and the second capacitor 609 may be electrically connected to the first DC busbar 640 through the second aperture 682. The first capacitor 608 and the second capacitor 609 may be electrically connected with the first conductive plate 607. Based on these connections, electrical current may be configured to flow from the second DC busbar 643, through the first capacitor 608, through the first conductive plate 607, through the second capacitor 609, and to the first DC busbar 640. In some cases, electrical current may be configured to flow from the first DC busbar 640, through the second capacitor 609, through the first conductive plate 607, through the first capacitor 608, and to the second DC busbar 643. The flow of electrical current described above may result in a smaller current loop between the interconnected components.

FIG. 7B depicts a bottom view of the one or more first capacitors 603 on a first side of the stacked busbar 635 without the protective housing 693. As depicted in FIG. 7B, the first capacitor 608 is electrically connected to the second capacitor 609 in a series configuration by the first conductive plate 607, and the first capacitor 612 is connected to the second capacitor 615 in a series configuration by the second conductive plate 613.

For each first and second capacitor connected in series among the one or more first capacitors 603, the first capacitor may be electrically connected to a first DC busbar, and the second capacitor may be electrically connected to a second DC busbar, or vice versa, by way of a respective aperture of the one or more first apertures provided for the first DC busbar 640 on the first side of the stacked busbar 635.

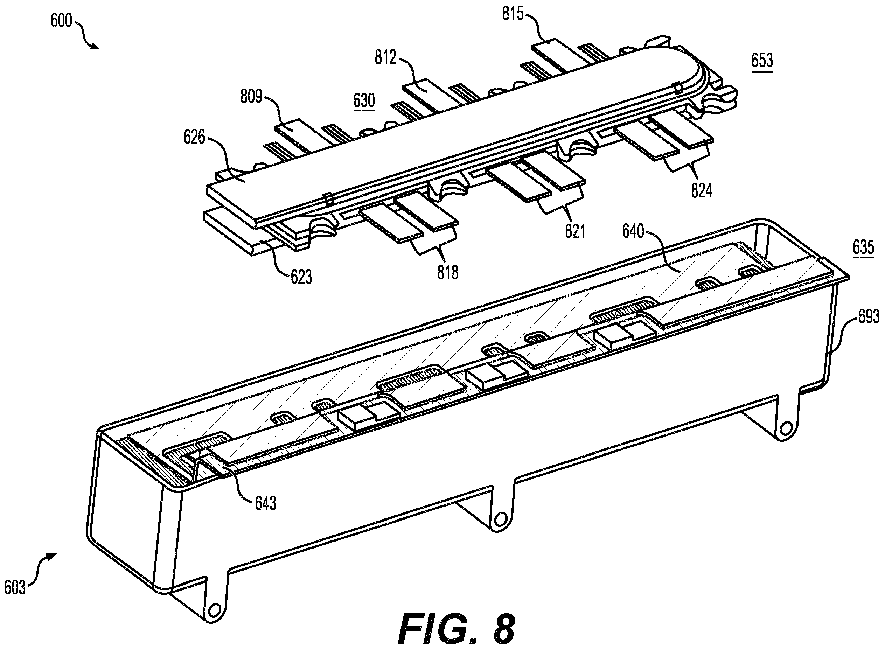

FIG. 8 depicts a portion of a bulk capacitor assembly for a first mounting stage, according to one or more embodiments. For example, FIG. 8 depicts a portion of the bulk capacitor assembly 600 including the heat sink assembly 653, the power module 630, and the one or more first capacitors 603. To assemble the bulk capacitor assembly 600, the one or more first capacitors 603 may first be placed on a mounting jig. Next, the heat sink assembly 653 with the power module 630 may be aligned and placed on the one or more first capacitors 603 as depicted. For example, each connector of the connector pairs 818, 821, and 824 of the power module 630 may connect to the first DC busbar 640 and/or the second DC busbar 643, respectively. Connectors 809, 812, and 815 of the power module 630 may connect to respective phases of a motor, such as the motor 190.

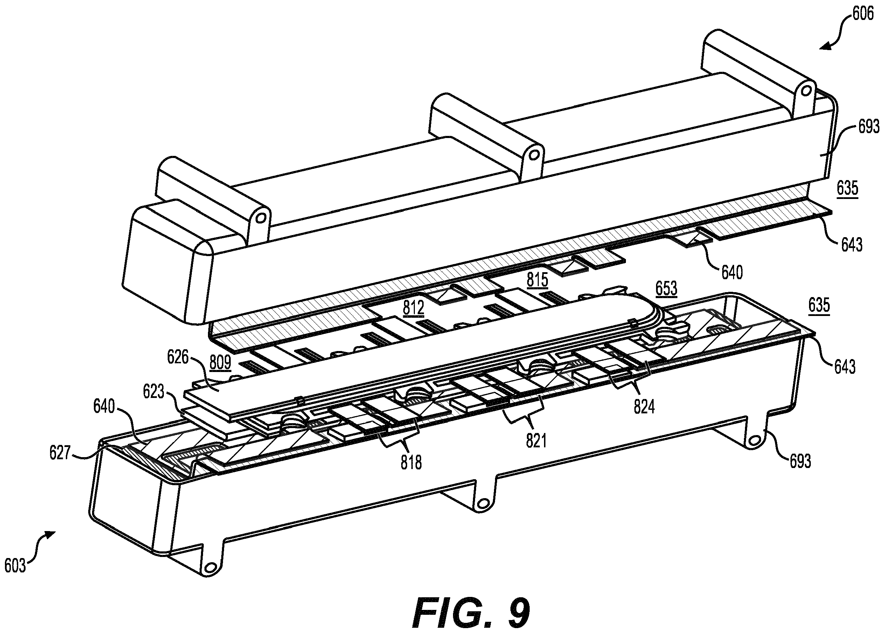

FIG. 9 depicts a portion of a bulk capacitor assembly for a second mounting stage, according to one or more embodiments. For example, FIG. 9 depicts a portion of the bulk capacitor assembly 600 including the heat sink assembly 653, the power module 630, the one or more first capacitors 603, and the one or more second capacitors 606. To continue assembling the bulk capacitor assembly 600, the one or more second capacitors 606 may be connected to the heat sink assembly 653, the power module 630, and the one or more first capacitors 603. In particular, the first cooling channel 623 may be mounted or coupled to the one or more first capacitors 603. The second cooling channel 626 may be mounted or coupled to the one or more second capacitors 606.

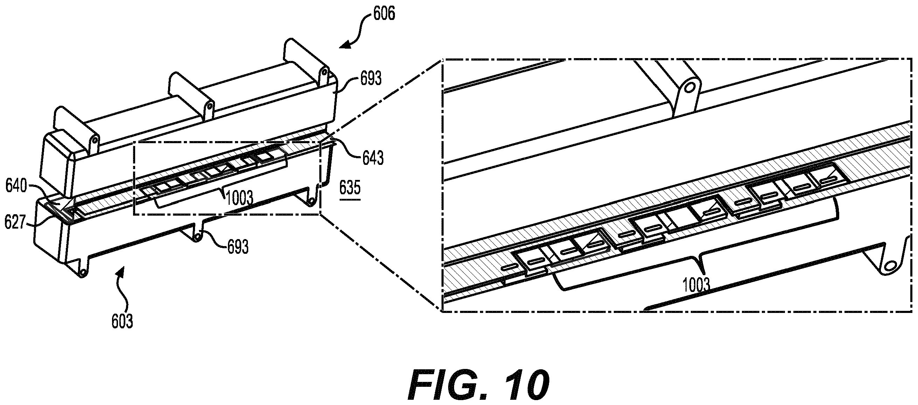

FIG. 10 depicts a portion of a bulk capacitor assembly for a laser welding stage, according to one or more embodiments. For example, FIG. 10 depicts a portion of the bulk capacitor assembly 600 including the one or more first capacitors 603 and the one or more second capacitors 606. Terminals 1003 of the first DC busbar 640 and the second DC busbar 643 of the first side and the second side of the stacked busbar 635 may be laser welded together to electrically connect the first side and the second side of the stacked busbar 635 and the power module 630. Once the two sides are connected, the one or more first capacitors 603 may be connected to the one or more second capacitors 606 in a parallel configuration.

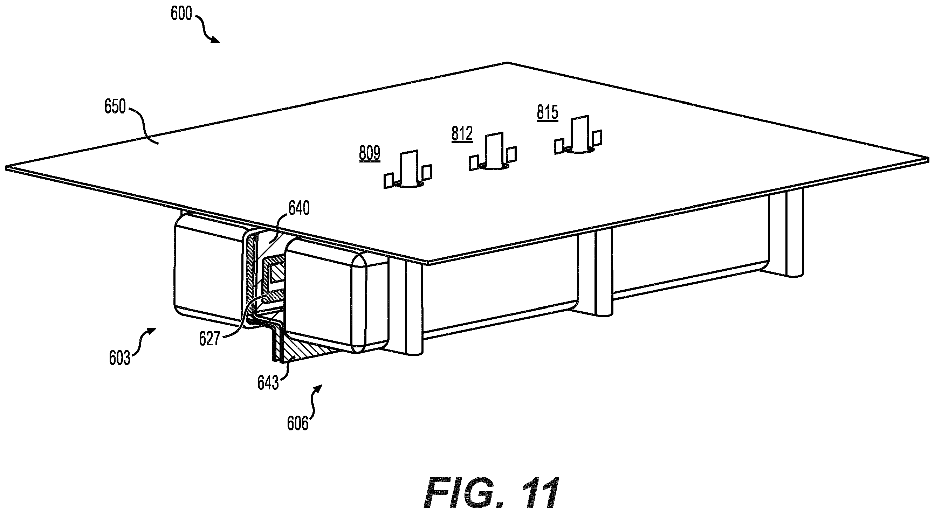

FIG. 11 depicts a finalized bulk capacitor assembly for an inverter, according to one or more embodiments. For example, the bulk capacitor assembly 600 may include the one or more first capacitor 603, the one or more second capacitor 606, the stacked busbar 635, which includes the first DC busbar 640 and the second DC busbar 643, the heat sink assembly 653, the power module 630, and the PCB 650. The PCB 650 may extend across the first side and the second side of the stacked busbar 635. The PCB 650 may facilitate a connection of the connectors 809, 812, and 815 of the power module 630 to a motor, such as the motor 190. The PCB 650 may facilitate a connection of one or more controllers or circuits that may control switching operations of the power module 630.

One or more embodiments as described in this disclosure may reduce the parasitic inductance of the switching loop involving a power module, which may reduce switching power loss. The power modules having a reduced semiconductor area may have the same performance as other power modules having a larger semiconductor area. One or more embodiments may reduce parasitic inductance of the power module and enable EMC compliance with minimal efforts. One or more embodiments may provide robust DC-link capacitors due to active cooling available on both sides of the power module.

Other embodiments of the disclosure will be apparent to those skilled in the art from consideration of the specification and practice of the invention disclosed herein. It is intended that the specification and examples be considered as exemplary only, with a true scope and spirit of the invention being indicated by the following claims.

## Claims

1. A bulk capacitor assembly for an inverter, the bulk capacitor assembly comprising:
a stacked busbar, the stacked busbar including a first direct current (DC) busbar and a second DC busbar;
one or more first capacitors on a first side of the stacked busbar, the one or more first capacitors electrically connected to the first DC busbar and the second DC busbar; and
one or more second capacitors on a second side of the stacked busbar, the first side being opposite to the second side, the one or more second capacitors electrically connected to the first DC busbar and the second DC busbar.

2. The bulk capacitor assembly of claim 1, wherein the first DC busbar includes one or more first apertures, and wherein the one or more first capacitors are electrically connected to the second DC busbar through the one or more first apertures, and
preferably wherein the second DC busbar includes one or more second apertures, the one or more second apertures corresponding to the one or more first apertures.

3. The bulk capacitor assembly of claim 1, wherein the first DC busbar includes one or more first apertures, wherein the one or more first capacitors are electrically connected to the first DC busbar at the one or more first apertures, and
wherein the second DC busbar includes one or more second apertures, the one or more second apertures corresponding to the one or more first apertures.

4. The bulk capacitor assembly of any one of claims 1 to 3, wherein the one or more first capacitors include:
a first capacitor electrically connected to the first DC busbar,
a second capacitor electrically connected to the second DC busbar, and
a conductive plate electrically connecting the first capacitor to the second capacitor in a series configuration,
wherein electrical current is configured to flow from the first DC busbar, through the first capacitor, through the conductive plate, through the second capacitor, and to the second DC busbar.

5. The bulk capacitor assembly of any one of claims 1 to 4, further comprising:
a power module electrically connected to the first DC busbar and the second DC busbar, wherein the power module is positioned between the first side of the stacked busbar and the second side of the stacked busbar.

6. The bulk capacitor assembly of claim 5, further comprising:
a heat sink assembly, wherein the heat sink assembly is positioned with the power module between the first side of the stacked busbar and the second side of the stacked busbar, and wherein the heat sink assembly is configured to cool the one or more first capacitors, the one or more second capacitors, the stacked busbar, and the power module, and
preferably further comprising a printed circuit board extending across the first side of the stacked busbar and the second side of the stacked busbar.

7. The bulk capacitor assembly of any one of claims 1 to 6, wherein a cross-section of the bulk capacitor assembly includes:
the one or more first capacitors on the first side of the stacked busbar;
the one or more second capacitors on the second side of the stacked busbar;
a power module between the first side of the stacked busbar and the second side of the stacked busbar; and
a heat sink assembly between the first side of the stacked busbar and the second side of the stacked busbar.

8. An inverter comprising:
the bulk capacitor assembly of any one of claims 1 to 7;
a power module configured to switch direct current electricity into alternating current; and
a heat sink assembly,
wherein the heat sink assembly is configured to cool the power module and the bulk capacitor assembly.

9. A vehicle comprising the inverter of claim 8.

10. A system comprising:
an inverter configured to convert DC power from a battery to AC power to drive a motor, wherein the inverter includes:
a power module; and
a bulk capacitor assembly, the bulk capacitor assembly including:
a stacked busbar, the stacked busbar including a first direct current (DC) busbar and a second DC busbar;
one or more first capacitors on a first side of the stacked busbar, the one or more first capacitors electrically connected to the first DC busbar and the second DC busbar; and
one or more second capacitors on a second side of the stacked busbar, the first side being opposite to the second side, the one or more second capacitors electrically connected to the first DC busbar and the second DC busbar.

11. The system of claim 10, further comprising:
a heat sink assembly, wherein the heat sink assembly is positioned with the power module between the first side of the stacked busbar and the second side of the stacked busbar, and wherein the heat sink assembly is configured to cool the one or more first capacitors, the one or more second capacitors, the stacked busbar, and the power module; and
a printed circuit board extending across the first side of the stacked busbar and
the second side of the stacked busbar, and
wherein the heat sink assembly preferably includes:
a first cooling channel; and
a second cooling channel,
wherein the power module is provided between the first cooling channel and the second cooling channel.

12. The system of any one of claims 10 to 11,
wherein the one or more first capacitors include:
a first capacitor electrically connected to the first DC busbar,
a second capacitor electrically connected to the second DC busbar, and
a conductive plate electrically connecting the first capacitor to the second capacitor in a series configuration,
wherein electrical current is configured to flow from the first DC busbar, through the first capacitor, through the conductive plate, through the second capacitor, and to the second DC busbar,
and/or
wherein a number of the one or more first capacitors is the same as a number of the one or more second capacitors.

13. A stacked busbar assembly for a bulk capacitor assembly for an inverter, the stacked busbar assembly comprising:
a first direct current (DC) busbar; and
a second DC busbar,
wherein the first DC busbar and the second DC busbar are arranged for one or more first capacitors to be provided on a first side of the stacked busbar assembly and for one or more second capacitors to be provided on a second side of the stacked busbar assembly,
wherein the first side is opposite to the second side.

14. The stacked busbar assembly of claim 13,
wherein the first DC busbar includes one or more first apertures,
wherein the one or more first capacitors are to be electrically connected to the second DC busbar through the one or more first apertures, and
wherein the second DC busbar includes one or more second apertures, the one or more second apertures corresponding to the one or more first apertures,
and/or
wherein the first DC busbar includes one or more first apertures,
wherein the one or more first capacitors are to be electrically connected to the first DC busbar at the one or more first apertures, and
wherein the second DC busbar includes one or more second apertures, the one or more second apertures corresponding to the one or more first apertures,
and/or
wherein the first DC busbar includes a first connection aperture and a through aperture,
wherein the second DC busbar includes a second connection aperture corresponding to the through aperture, and an isolation aperture corresponding to the first connection aperture,
wherein the first connection aperture is configured to electrically connect the first DC busbar to a first capacitor of the one or more first capacitors, and
wherein the second connection aperture is configured to electrically connect the second DC busbar to a second capacitor of the one or more first capacitors through the first through aperture.
